Europäisches Patentamt

(19) European Patent Office

Office européen des brevets

(11) Veröffentlichungsnummer: **0 146 724**
**B1**

(12) **EUROPÄISCHE PATENTSCHRIFT**

(45) Veröffentlichungstag der Patentschrift:
**13.05.87**

(51) Int. Cl.⁴: **C 23 C 18/22**

(21) Anmeldenummer: **84112977.8**

(22) Anmeldetag: **27.10.84**

(54) **Verfahren zur Vorbehandlung von Polyamidsubstraten für die stromlose Metallisierung.**

(30) Priorität: **04.11.83 DE 3339857**

(43) Veröffentlichungstag der Anmeldung:
**03.07.85 Patentblatt 85/27**

(45) Bekanntmachung des Hinweises auf die Patenterteilung:
**13.05.87 Patentblatt 87/20**

(84) Benannte Vertragsstaaten:
**BE CH DE FR GB IT LI NL SE**

(56) Entgegenhaltungen:
**EP - A - 0 081 129**

(73) Patentinhaber: **BAYER AG, Konzernverwaltung RP
Patentabteilung, D-5090 Leverkusen 1 Bayerwerk (DE)**

(72) Erfinder: **Sirinyan, Kirkor, Dr., Humperdinckstrasse 12,
D-5060 Bergisch Gladbach 2 (DE)**
Erfinder: **Wolf, Gerhard, Dieter, Dr.,
Wilhelm-Busch-Strasse 29, D-4047 Dormagen 5 (DE)**
Erfinder: **Merten, Rudolf, Dr.,
Berta-von-Suttner-Strasse 55, D-5090 Leverkusen (DE)**
Erfinder: **von Gizycki, Ulrich, Dr., Wiembach Allee 24,
D-5090 Leverkusen 3 (DE)**

**Beschreibung**

Gegenstand der Erfindung ist ein relativ schonendes Verfahren zur Vorbehandlung von Substratoberflächen von Formteilen aus synthetischem Polyamid für das Ausbringen haftfester Metallbeschichtungen durch chemogalvanische Metallisierung.

Es ist allgemein bekannt, dass die für zahlreiche Kunststoffgegenstände übliche Vorbehandlung durch Ätzen mit stark oxidierenden Säuren für Polyamidsubstrate ungeeignet ist.

Es ist deshalb bereits vorgeschlagen worden (vgl. DE-A 2 946 343), das Polyamidsubstrat zunächst mit einer wässrigen alkalischen Lösung mit einem pH-Wert von mindestens etwa 10 bei erhöhter Temperatur vorzubehandeln, bevor mit einer organischen Säure geätzt wird. Für den letzten Schritt wurden vorzugsweise Trichlor- und Trifluoressigsäure eingesetzt, deren Handhabung wegen ihrer Flüchtigkeit und hohen Toxizität aufwendige Arbeitsschutzmassnahmen erfordert. Darüber hinaus führt diese immer noch sehr drastische Vorbehandlungsmethode zu einer nicht reversiblen Verschlechterung der wichstigsten mechanischen Eigenschaften der Polyamidformkörper.

Gemäss DE-A 3 137 587 wird der Versuch unternommen, diese Nachteile dadurch zu beheben, dass man die Polyamidsubstrate mit einem Gemisch aus wasserhaltiger Säure und einem wasserlöslichen, auf Polyamid quellend wirkenden organischen Lösungsmittel vorbehandelt. Es zeigte sich jedoch, dass auch dieses Ätzverfahren die Polyamidformkörper derart schädigt, dass diese für zahlreiche Zwecke nicht einsetzbar sind.

In der DE-A 2 022 109 wird ein Verfahren zur Vorbehandlung von zu metallisierenden Kunststoff-Formkörpern beschrieben, welches dadurch gekennzeichnet ist, dass man den Kunststoff in Anwesenheit eines ihn (an)lösenden oder anquellenden Lösungsmittels mit einem gelösten Metallsalzkomplex behandelt. Als Kunststoff wird auch Polyamid erwähnt. Bei den Komplexsalzen handelt es sich im wesentlichen um Komplexe des Dimethylsulfoxids mit LiCl, $SnCl_2$, $ZnCl_2$, $FeCl_2$, $FeCl_3$, $Hg_2Cl_2$, $MnCl_2$, $AgNO_3$, u.a. Als Aktivatorlösung wird beispielhaft nur eine ammoniakalische Silbernitratlösung beschrieben. Bei der Nacharbeitung dieser Methode wurden jedoch nur Metallauflagen mit ungenügender Haftfestigkeit erzielt. Auch führen die $AgNO_3$-aktivierten Substrate oft zum Zusammenbrechen der Metallisierungsbäder.

Aus der EP-A 0 081 129 (Beispiele 11 und 12) ist schliesslich ein Verfahren zur Vorbehandlung von Polyamidwerkstoffen bekannt, bei dem das Substrat zunächst mit Natronlauge entfettet, anschliessend mit einer Aktivierungslösung, enthaltend Methanol (und ggf. Methylenchlorid), $CaCl_2$ und einen Palladiumolefindichlorid-Komplex aktiviert und nach dem Spülen mit Methanol und Trocknen in ein stromlos arbeitendes Metallisierungbad eingebracht wird.

Diese an sich sehr elegante Methode hat allerdings den Nachteil, dass die nach diesem Verfahren abgeschiedenen Metallauflagen den hohen Anforderungen der Temperaturwechselprüfung gemäss DIN 53 496 nicht genügen.

Es wurde nun überraschenderweise gefunden, dass man diese Nachteile weitgehend vermeiden und zu gut haftenden Metallbeschichtungen auf Polyamidsubstraten gelangen kann, ohne deren mechanische Eigenschaften, wie Kerbschlagzähigkeit, Schlagzähigkeit und Festigkeit negativ zu beeinflussen, wenn man die Substrate — in an sich beliebiger Reihenfolge — mit

a) einer Lösung eines Gemisches von Halogeniden der Elemente der Gruppen Ia oder IIa des Periodensystems mit Sulfaten, Nitraten oder Chloriden von Metallen der Gruppen IIIa, IIIb, IVa, IVb, VIa, VIIa oder von Nichtedelmetallen der Gruppe VIIIa des Periodensystems in einem nichtätzenden, organischen Quell- oder Lösungsmittel für Polyamide und

b) einer metallorganischen Komplexverbindung von Elementen der Gruppen Ib oder VIIIa des Periodensystems

behandelt.

Geeignete Halogenide von Elementen der 1. und 2. Hauptgruppe sind insbesondere die Chloride; bevorzugt sind LiCl, $BeCl_2$, $MgCl_2$ und $CaCl_2$.

Beispiele für die bevorzugt einzusetzenden Chloride der Metalle der erwähnten Gruppen III-VIII sind: $FeCl_2$, $FeCl_3$, $TiCl_3$, $TiCl_4$, $BCl_3$ und insbesondere $AlCl_3$.

Geeignete Quell- und Lösungsmittel sind solche wie sie in üblichen Handbüchern über Polyamide beschrieben sind [vgl. z.B. «Die Polyamide» von Hopff, Müller, Wegner, Springer-Verlag (1954), sowie «Polymer Handbook» von Brandrup et al, New York, Band IV (1975) sowie «Kunststoffhandbuch» von Vieweg/Müller; Band IV (1966)]. Beispielsweise seien genannt: niedrige aliphatische und araliphatische Alkohole, wie z.B. Methanol, Ethanol, Isopropanol, n-Propanol, N-Butanol, Benzylalkohol und Phenylethylalkohol. Besonders bevorzugt ist Methanol. Auch Dimethylformamid und amidgruppenhaltige Lösungsmittel, wie Formamid und Dimethylformamid, kommen in Betracht. Selbstverständlich sind auch Mischungen dieser Lösungsmittel einsetzbar.

Gewünschtenfalls können auch übliche Polyamidweichmacher (0,2-10 Gew.-%, vorzugsweise 0,5-5 Gew.-%, bezogen auf die gesamte Flüssigkeitsmenge) zugesetzt werden. Beispielhaft seien Benzolsulfonsäuremonoethylamid, p-Toluolsulfonsäureamid, Dioxidiphenylsulfon und Dibenzylphenol genannt.

Die Gesamtmenge der erfindungsgemäss zu verwendenden Salzgemische beträgt vorzugsweise 2,5-25 Gew.-% (besonders bevorzugt 5-15 Gew.-%) bezogen auf die Flüssigkeitsmenge. Der Anteil der Salze schwacher Basen sollte 30% nicht übersteigen (bezogen auf die Gesamtsalzmenge, die bis zur jeweiligen Löslichkeitsgrenze ansteigen kann). Vorzugsweise beträgt der Anteil dieser Salze 0,1 bis 6%, insbesondere 0,5-3%. Die Komplexverbindungen gemäss b) sind allgemein bekannt (vgl. EP-A 0 043 485). Geeignet sind z.B. Palladiumkomplexe von 1,3-Diketonen sowie vor allem von 1,3-Dienen und $\alpha,\beta$-ungesättigten Ketonen. Besonders geeignet sind solche Metallkomplexe (vorzugsweise Pd-II-Komplexe), deren organische Liganden über die zur Metallbindung erforderlichen Gruppen hinaus wenigstens eine weitere funktionelle Gruppe zur Verankerung an der Substratoberfläche aufweisen (vgl. EP-A 0 081 129).

Ganz besonders geeignet sind Koordinationskomplexe von Olefinen mit Palladium, die folgende funktionelle Gruppen aufweisen:

-COOH, -COCl, -COF, -COBr, -CO-O-CO-, $CONH_2$, COO-Alkyl, -CO-NH-CO-, -CO- und -NHCO-.

Die metallorganischen Verbindungen werden zweckmässigerweise in Form ihrer Dispersionen und insbesondere ihrer Lösungen in geeigneten organischen Lösungsmitteln eingesetzt. Die Konzentration soll zwischen 0,01 g und 10 g pro Liter Lösungsmittel betragen. Neben den oben genannten Lösungsmitteln für Metallsalze kommen auch niedrigsiedende, indifferente, mit Wasser nicht mischbare Typen in Betracht, z.B. ggf. chlorierte Kohlenwasserstoffe wie $HCCl_3$, $CCl_4$, $CH_2Cl_2$, $CICH = CCl_2$, $Cl_2C = CCl_2$, Toluol u.a.m.

Wie bereits erwähnt können die Salzlösungen gemäss a) und die Komplexe gemäss b) prinzipiell in beliebiger Reihenfolge auf das Substrat aufgebracht werden, d.h. zuerst a) und dann b) — oder — zuerst b) und dann a) — oder — a) und b) gemeinsam. Die Behandlung erfolgt im allgemeinen bei −15°C bis zum Siedepunkt der verwendeten Lösungsmittel, vorzugsweise bei 15-30°C, während 1-1800 Sekunden.

Eine bevorzugte Verfahrensvariante besteht darin, dass man das Substrat zunächst mit der metallkomplexhaltigen Aktivatorlösung und danach mit dem Quell- bzw. Lösungsmittelsystem behandelt.

Bei der praktischen Durchführung dieser Variante geht man zweckmässigerweise so vor, dass man den Polyamidformkörper

1) bei Raumtemperatur in die metallsalzfreie Aktivatorlösung eintaucht,

2) nach 0,5-10 Minuten, vorzugsweise 1-5 Minuten, aus dem Bad entfernt,

3) danach 3-10 Minuten bei Raumtemperatur mit der Lösung des Salzgemisches in dem PA-Quell- bzw. Lösungsmittel behandelt,

4) von anhaltendem Lösungsmittel befeit,

5) anschliessend in ein Sensibilisierungsbad überführt und

6) schliesslich der stromlosen Metallisierung unterwirft.

Die Entfernung der Lösungsmittel im Schritt 4) erfolgt im allgemeinen durch Verdampfen, ggf. unter reduziertem Druck. Höhersiedende Lösungsmittel werden zweckmässigerweise durch Extraktion oder Spülen mit niedrigsiedenden Lösungsmitteln entfernt.

Die Sensibilisierung kann grundsätzlich in den üblichen sauren Bädern auf der Basis von $SnCl_2$- und $ZnCl_2$-Lösungen erfolgen. Vorzugsweise wird sie jedoch in alkalischen Bädern mit Formalin, Dimethylboran, Natriumborhydrid, Hydrazin, sowie Natriumhypophosphit durchgeführt. Ganz besonders bevorzugt ist die Sensibilisierung in ammoniakalkalischen wässrigen Alkohollösungen (Methanol, Ethanol), welche die vorstehend genannten Reduktionsmittel enthalten, bei Raumtemperatur während 1-5 Minuten.

Die sensibilisierten Oberflächen können direkt oder nach einem Spülgang (zur Beseitung von Reduktionsmittelresten) in herkömmliche Metallisierungsbäder eingebracht werden.

Eine ganz besonders bevorzugte Ausführungsform des erfindungsgemässen Verfahrens besteht darin, dass die Reduktion im Metallisierungsbad gleich mit dem Reduktionsmittel der stromlosen Metallisierung durchgeführt wird. Diese Ausführung stellt eine bisher nicht mögliche Vereinfachung der stromlosen Metallisierung dar. Diese Ausführungsform besteht nur noch aus folgenden Arbeitsgängen: Eintauchen des Substrats in die Lösung der Komplex-Verbindung, Behandeln mit dem Quellmittelsystem, Verdampfen des Lösungsmittels und Eintauchen der so aktivierten Oberflächen in das Metallisierungsbad (Reduktion und Metallisierung).

Diese Variante ist ganz besonders für aminboran- oder hypophosphithaltige Nickelbäder oder formalinhaltige Kupferbäder geeignet.

Die auf diese Weise auf den Polyamidwerkstoffen erzeugten Metallauflagen können gewünschtenfalls noch galvanisch verstärkt werden. Für diese elektrische Metallabscheidung eignen sich vor allem Cu, Ni, Cr, Ag, Au und Pt. Dabei empfiehlt es sich zunächst eine galvanische Vorverstärkung bis zu Schichtdicken von ca. 20 µm in schwach sauren oder basischen Galvanisierungsbädern, beispielsweise in Ni-Bädern bei pH 5-6 vorzunehmen.

Das erfindungsgemässe Verfahren ist auf sämtliche handelsüblichen Polyamidtypen — wie Polyamid-6, Polyamid-6,6, Polyamid-10, -11 und -12 sowie Mischtypen — anwendbar. Es können sowohl füllstoffhaltige als auch ungefüllte Polyamide mit gleichem Erfolg behandelt werden. Füllstoffbeimischungen verkürzen je nach Anteil die erforderliche Ätzzeit gegenüber dem ungefüllten Polyamid.

Darüber hinaus sind extrem schlagfeste Substrate, wie mit Kautschuk-, Polyisopren- oder Polybutadien-Latices gepfropfte oder gemischte Polyamide bestens geeignet.

*Beispiel 1*

Eine 90 × 150 × 3 mm starke glasfaserverstärkte (30%) Kunststoffplatte aus Polyamid-6 wird 1,5 Minuten in 0,7 g 4-Cyclohexen-1,2 dicarbonsäureanhydridpalladium(II)chlorid und 1 Liter $CH_2Cl_2$ bei Raumtemperatur (RT) aktiviert, getrocknet und in einem Bad, welches

1400 ml Methanol (technisch)
123 g $CaCl_2$
2,0 g $AlCl_3$

enthält, 5 Minuten bei RT behandelt. Anschliessend wird die Platte in einem Bad, bestehend aus

1200 ml Ethanol (technisch)
24 ml $NH_3$-Lösung (25%ig)
50 ml 2n-DMAB-(Dimethylaminboran)

5 Minuten bei RT sensibilisiert, mit destilliertem Wasser gespült und dann in einem herkömmlichen hypophosphithaltigen Vernickelungsbad bei 30°C 25 Minuten vernickelt. Die Haftfestigkeit der Metallauflage, bestimmt durch die Abzugskraft nach DIN 53 494, beträgt ≥ 60 N/25 mm.

Die galvanische Verstärkung von Polyamid-Platten für die Bestimmung der Abzugskraft wird wie folgt durchgeführt.

a) eine halbe Minute Dekapieren in 10%iger $H_2SO_4$
b) Spülen
c) 5 Minuten im Halbglanznickelbad Spannung 9 Volt, Badtemperatur 60°C
d) Spülen
e) eine halbe Minute Dekapieren
f) 90 Minuten im Kupferbad; Spannung 1,9 Volt, Badtemperatur 28°C
g) Spülen

*Beispiel 2*

Ein Formteil aus einem mit 30 Gew.-% glasfaserverstärkten Polyamid-6 wird nach Beispiel 1 behandelt, aktiviert, sensibilisiert, auf dem chemischen Wege vernickelt und dann galvanisch verstärkt. Die galvanische Verstärkung wird wie folgt durchgeführt:

a) eine halbe Minute Dekapieren in 10%iger $H_2SO_4$
b) Spülen
c) 5 Minuten im Halbglanznickelbad; Spannung 4 Volt, Badtemperatur 60°C, abgeschiedene Halbglanznickelschicht: ca. 4 bis 5 μm
d) Spülen
e) eine halbe Minute Dekapieren
f) 30 Minuten im Kupferbad, Spannung 1,9 Volt, Badtemperatur 28°C, aufgebrachte Kupferschicht 15 bis 16 μm
g) Spülen
h) eine halbe Minute Dekapieren
i) 8 Minuten Glanznickelbad, Spannung 5,5 Volt, Badtemperatur 52°C, abgeschiedene Nickelschicht ca. 20 μm
j) Spülen
k) Tauchen in Oxalsäure (0,5%ige wässrige Lösung)
l) 3 Minuten Glanzchrombad, Spannung 4,5 Volt, Badtemperatur 40°C, abgeschiedene Chromschicht ca. 0,3 μm
m) Spülen
n) Entgiften in einer 40%igen Bisulfitlösung
o) Spülen in destilliertem Wasser

Der so metallisierte Formkörper wurde der Temperatur-Wechselprüfung nach DIN 53 496 ausgesetzt, wobei die Wärmelagerung bei +110°C und die Kältelagerung bei −40°C erfolgte. Die Metallauflage haftet an der Formkörperoberfläche so fest, dass sie keine Veränderung zeigt.

*Beispiel 3*

Normstäbchen aus einem mit 30 Gew.-% glasfaserverstärkten Polyamid-6 werden nach Beispiel 1 vorbehandelt, sensibilisiert und chemisch vernickelt. Aus den Schlagzähigkeitsuntersuchungen nach DIN 53 453/isoR179 geht hervor, dass ihre Schlagzähigkeit von dem Gesamtmetallisierungsvorgang nicht beeinflusst wird.

*Beispiel 4*

Eine 90 × 150 × 3 mm·starke Kunststoffplatte aus einem kautschuk-gepfropften Polyamid-6 wird in einer Haftaktivierungslösung von 1,0 g Mesityloxid-palladiumchlorid

1400 ml Methanol (technisch)
140 g $CaCl_2$
3,0 g $AlCl_3$
400 ml $H_2O_{dest.}$

bei 25°C 5 Minuten haftaktiviert, gemäss Beispiel 1 sensibilisiert, mit destilliertem Wasser gespült, auf dem chemischen Wege vernickelt und dann gemäss Beispiel 1 galvanisch verstärkt. Die Metallauflage haftet an der Plattenoberfläche sehr gut. Ihre Haftfestigkeit bestimmt nach DIN 53 494 beträgt 60 N/25 mm.

*Beispiel 5*

Ein Formteil aus kautschuk-modifiziertem Polyamid-6 wird gemäss Beispiel 4 haftaktiviert, gemäss Beispiel 1 sensibilisiert, in einem handelsüblichen, chemischen Verkupferungsbad verkupfert, gemäss Beispiel 2 mit einer galvanischen Metallauflage verstärkt und dann gemäss Beispiel 2 dreimal der Temperatur-Wechselprüfung ausgesetzt. Die Metallauflage haftet an der Formkörperoberfläche so fest, dass sie keine Veränderungen zeigt.

*Beispiel 6*

Ein Normstäbchen aus kautschuk-modifiziertem Polyamid-6 wird gemäss Beispiel 4 haftaktiviert, gemäss Beispiel 1 sensibilisiert bzw. vernickelt und dann gemäss Beispiel 3 der Schlagzähigkeitsprüfung ausgesetzt. Der Schlagzähigkeitswert beträgt sowohl bei unbehandelten als auch bei vernickelten Proben 70 kJ/m².

*Beispiel 7*

Ein Formteil aus mit 40 Gew.-% Mineralfasern verstärktem Polyamid-6 (kautschuk-modifiziert) wird in einer Haftaktivierungslösung, welche aus

1400 ml Ethanol
120 g $CaCl_2$
5,0 g $AlCl_3$
1,5 g 4-Cyclohexen-1,2-dicarbonsäureanhydrid-palladium(II)chlorid

besteht, bei 20°C 5 Minuten haftaktiviert, gewaschen, gemäss Beispiel 1 sensibilisiert, vernickelt und dann gemäss Beispiel 2 galvanisch verstärkt. Die Metallauflage haftet an der Formkörperoberfläche so fest, dass sie die Temperatur-Wechselprüfung gemäss Beispiel 2 besteht.

*Beispiel 8*

Normstäbchen werden gemäss Beispiel 7 behandelt, gemäss Beispiel 1 vernickelt und dann gemäss Beispiel 3 der Schlagzähigkeitsprüfung ausgesetzt. Es zeigt sich, dass die Schlagzähigkeit des Materials nicht beeinflusst wird. Die Schlagzähigkeitswerte von vernickelten, bzw. nicht behandelten Normstäbchen sind > 140 kJ/m². Die Abzugsfestigkeit der Metallauflage beträgt ⩾ 50 N/25 mm.

*Beispiel 9*

Eine 90 × 150 × 3 mm starke Kunststoffplatte aus einem handelsüblichen Polyamid-6,6 mit 30 Gew.-% Glasfasern wird 5 Minuten in einem Bad aus

1500 ml   EtOH
120   g   $CaCl_2$
20 ml   p-Toluolsulfonamid
3   g   $AlCl_3$
1,2   g   n-3-Hepten-2-on-palladiumchlorid

bei RT behandelt, bei RT getrocknet und dann gemäss Beispiel 1 mit einer Metallauflage versehen. Man bekommt einen Metall-Polymer-Verbundwerkstoff mit einer guten Haftfestigkeit.

*Beispiel 10*

Ein Formkörper aus kautschuk-modifiziertem Polyamid wird in einer Lösung aus

400 ml   Methanol
50 ml   n-Butanol
120   g   $CaCl_2$
2   g   $TiCl_4$

bei 30°C 6 Minuten behandelt, getrocknet, gemäss Beispiel 1 aktiviert, sensibilisiert, vernickelt und dann gemäss Beispiel 2 galvanisiert. Die Metallauflage haftet auf der Polymeroberfläche so gut, dass sie die Temperatur-Wechselprüfung nach DIN 53 436 besteht.

*Beispiel 11*

Eine 90 × 150 × 3 mm starke Kunststoffplatte aus Polyamid-6,6 mit 40 Gew.-% Glasfasern, wird gemäss Beispiel 1 aktiviert, in einem isopropanolischen Bad, welches pro Liter Lösung

120   g $MgCl_2$
2,0 g $AlCl_3$
125   ml $H_2O_{dest.}$

enthält, 10 Minuten bei RT behandelt.

Anschliessend wird die Platte in einem Bad, welches aus

1000 ml   n-Butanol
10   g   Kalium-t-butylat
8   g   wässrige $NH_2$-$NH_2$-Lösung (30%)

besteht, bei 30°C sensibilisiert, gewaschen, in einem handelsüblichen Verkupferungsbad verkupfert und dann gemäss Beispiel 1 galvanisch verstärkt. Man bekommt einen Metall-Polymer-Verbundwerkstoff mit einer guten Abzugsfestigkeit.

Der Kerbschlagfestigkeitswert nach DIN 53 453 wird von dem chemischen Metallisierungs- bzw. Vorbehandlungsvorgang nicht beeinflusst.

**Patentansprüche**

1. Verfahren zur Vorbehandlung von Substratoberflächen von Formteilen aus Polyamiden für die stromlose Metallisierung, wobei man die Substrate in an sich beliebiger Reihenfolge mit

a) einer Lösung eines Gemisches von Halogeniden der Elemente der Gruppen Ia oder IIa des Periodensystems mit Sulfaten, Nitraten oder Chloriden von Metallen der Gruppen IIIa, IIIb, IVa, IVb, VIa, VIIa oder von Nichtedelmetallen der Gruppe VIIIa des Periodensystems in einem nichtätzenden, organischen Quell- oder Lösungsmittel für Polyamid und

b) einer metallorganischen Komplexverbindung von Elementen der Gruppen Ib oder VIIIa des Periodensystems

behandelt.

2. Verfahren nach Anspruch 1, dadurch gekennzeichnet, dass man die Substrate zunächst mit einer die metallorganischen Komplexverbindungen enthaltenden Aktivatorlösung und anschliessend mit der Lösung des Salzgemisches behandelt.

3. Verfahren nach Anspruch 1, dadurch gekennzeichnet, dass die so behandelten Substrate direkt in die Metallisierungsbäder eingebracht werden.

4. Verfahren nach Anspruch 1, dadurch gekennzeichnet, dass man ein Gemisch von LiCl, $BeCl_2$, $MgCl_2$ oder $CaCl_2$ mit $FeCl_2$, $FeCl_3$, $TiCl_3$, $TiCl_4$, $BCl_3$ oder $AlCl_3$ einsetzt.

5. Verfahren nach Anspruch 1, dadurch gekennzeichnet, dass man ein Gemisch aus $CaCl_2$ und $AlCl_3$ einsetzt.

6. Verfahren nach Anspruch 1, dadurch gekennzeichnet, dass man das Salzgemisch in einer Lösung in niederen aliphatischen oder araliphatischen Alkoholen einsetzt.

7. Verfahren nach Anspruch 1, dadurch gekennzeichnet, dass man mit einer Lösung von $CaCl_2$ und $AlCl_3$ in Methanol vorbehandelt.

8. Verfahren nach Anspruch 1, dadurch gekennzeichnet, dass man als Komplexverbindung einen Palladium-II-Komplex von 1,3-Dienen oder $\alpha,\beta$-ungesättigten Ketonen einsetzt.

9. Verfahren nach Anspruch 1, dadurch gekennzeichnet, dass man als Komplexverbindung einen Olefinkomplex des Palladium-II einsetzt, dessen Liganden über die zur Metallbindung erforderlichen Gruppen hinaus wenigstens eine weitere funktionelle -COOH, -COCl, -COF, -COBr, -CO-O-CO-, -$CONH_2$, COO-Alkyl, -CO-NH-CO, -CO- und -NHCO-Gruppe aufweisen.

10. Verfahren nach Anspruch 1, dadurch gekennzeichnet, dass man die vorbehandelten Substrate in einem alkalischen aminoboranhaltigen, hydrazinhaltigen oder formalinhaltigen Reduktionsbad behandelt.

**Claims**

1. Process for pretreating substrate surfaces of mouldings of polyamides for electroless metallisation, wherein the substrates are treated, in basically any desired sequence, with

a) a solution of a mixture of halides of the elements of groups Ia or IIa of the periodic system with sulphates, nitrates or chlorides of metals of goups IIIa, IIIb, IVa, IVb, VIa, VIIa or of base metals of groups VIIIa of the periodic system in a non-etching, organic swelling agent or solvent for polyamides and

b) a metal-organic complex compound of elements of groups Ib or VIIIa of the periodic system.

2. Process according to Claim 1, characterized in that the substrates are first treated with an activator solution containing the metal-organic complex compounds and then with the solution of the salt mixture.

3. Process according to Claim 1, characterized in that the substrates thus treated are introduced directly into the metallisation baths.

4. Process according to Claim 1, characterized in that a mixture of LiCl, BeCl$_2$, MgCl$_2$ or CaCl$_2$ with FeCl$_2$, FeCl$_3$, TiCl$_3$, TiCl$_4$, BCl$_3$ or AlCl$_3$ is used.

5. Process according to Claim 1, characterized in that a mixture of CaCl$_2$ and AlCl$_3$ is used.

6. Process according to Claim 1, characterized in that the salt mixture is used in a solution in lower aliphatic or araliphatic alcohols.

7. Process according to Claim 1, characterized in that the pretreatment is carried out with a solution of CaCl$_2$ and AlCl$_3$ in methanol.

8. Process according to Claim 1, characterized in that the complex compound used is a palladium-II complex of 1,3-dienes or $\alpha,\beta$-unsaturated ketones.

9. Process according to Claim 1, characterized in that the complex compound used is an olefine complex of palladium-II, the ligands of which contain, in addition to the groups required for the metal bond, at least one further functional -COOH, -COCl, -COF, -COBr, -CO-O-CO-, -CONH$_2$,- COO-alkyl, -CO-NH--CO, -CO- and -NHCO-group.

10. Process according to Claim 1, characterized in that the pretreated substrates are treated in an alkaline reducing bath containing aminoborane, hydrazine or formalin.

## Revendications

1. Procédé pour le traitement préalable des surfaces de pièces moulées en polyamide en vue d'une métallisation sans application de courant électrique, dans lequel on traite les supports, dans un ordre quelconque, par
a) une solution d'un mélange d'halogénures des éléments des groupes Ia ou IIa de la Classification Périodique des sulfates, des nitrates ou des chlorures de métaux des groupes IIIa, IIIb, IVa, IVb, VIa, VIIa ou des métaux non nobles du groupe VIIIa de la Classification Périodique dans un gonflant ou solvant organique pour polyamides, n'attaquant pas ces derniers, et
b) un complexe organométallique d'éléments des groupes Ib ou VIIIa de la Classification Périodique.

2. Procédé selon la revendication 1, caractérisé en ce que l'on traite d'abord les supports par une solution d'activateur contenant les complexes organométalliques puis par la solution du mélange de sels.

3. Procédé selon la revendication 1, caractérisé en ce que l'on introduit les supports ainsi traités directement dans les bains de métallisation.

4. Procédé selon la revendication 1, caractérisé en ce que l'on utilise un mélange de LiCl, BeCl$_2$, MgCl$_2$, ou CaCl$_2$ avec FeCl$_2$, FeCl$_3$, TiCl$_3$, TiCl$_4$, BCl$_3$ ou AlCl$_3$.

5. Procédé selon la revendication 1, caractérisé en ce que l'on utilise un mélange de CaCl$_2$ et AlCl$_3$.

6. Procédé selon la revendication 1, caractérisé en ce que l'on utilise le mélange de sels en solution dans des alcools aliphatiques ou araliphatiques inférieurs.

7. Procédé selon la revendication 1, caractérisé en ce que l'on soumet à un traitement préalable à l'aide d'une solution de CaCl$_2$ et AlCl$_3$ dans le méthanol.

8. Procédé selon la revendication 1, caractérisé en ce que l'on utilise en tant que complexe un complexe de palladium-II et de 1,3-diène ou d'une cétone alpha,bêta-insaturée.

9. Procédé selon la revendication 1, caractérisé en ce que l'on utilise en tant que complexe un complexe d'oléfine du palladium-II dont les ligands contiennent, en plus des groupes nécessaires pour la liaison avec le métal, au moins un autre groupe fonctionnel -COOH, -COCl, -COF, -COBr, -CO-O-CO-, -CONH$_2$, COO-alkyle, -CO-NH-CO, -CO- et -NHCO-.

10. Procédé selon la revendication 1, caractérisé en ce que l'on traite les supports ayant subi le traitement préalable dans un bain réducteur alcalin contenant un aminoborane, de l'hydrazine ou du formaldéhyde.